# EUROPEAN PATENT SPECIFICATION

(11) **EP 0 556 790 B1**
(45) Date of publication and mention of the grant of the patent: **09.12.1998**
(21) Application number: 93102457.4
(22) Date of filing: 17.02.1993
(51) Int. Cl.: C08J 5/18, C08J 5/00, B05D 3/06, B32B 27/28, B32B 27/38, B32B 15/20

(54) **Polyimide surfaces having enhanced adhesion**
Polyimidoberflächen mit erhöhter Adhäsion
Surfaces de polyimide à adhésion augmentée

(30) Priority: 18.02.1992 US 835857
(43) Date of publication of application: 25.08.1993
(73) Proprietor: MINNESOTA MINING AND MANUFACTURING COMPANY, St. Paul, Minnesota 55133-3427 (US)
(72) Inventor: Murray, Cameron T., c/o Minnesota Mining and, St. Paul, Minnesota 55133-3427 (US); Ouderkirk, Andrew J., c/o Minnesota Mining and, St. Paul, Minnesota 55133-3427 (US); Dunn, Douglas S., c/o Minnesota Mining and, St. Paul, Minnesota 55133-3427 (US)
(74) Representative: VOSSIUS & PARTNER

(56) References cited:
- EP-A- 0 108 189
- US-A- 4 822 451
- US-A- 5 151 304

## Description

The present invention relates to ordered amorphous polymers having a disordered surface to which coatings and laminates have an improved adherence, and particularly to polyimide (PI) polymers to which high glass transition temperature (T_{g}) epoxy resins have improved adherence. The invention also relates to a process for producing the disordered amorphous surface layer.

Polyimide films and coatings have a chemical structure and morphology that are useful in high temperature applications. This morphology results in surfaces that are poor adherends, e.g., they are difficult to bond to with a high level of adhesion. Poor adhesion to commercial polyimide films is likely a result of the oriented amorphous molecules located in the plane of the film at the surface. Such an oriented morphology exhibits low permeation of the surface by organic molecules, low surface layer cohesion due to weak intermolecular attractions, a very smooth surface and reduced chemical functionality at the surface. The amorphous orientation of polymers like polyimide produces useful bulk properties such as high tensile and flexural modulus. These characteristics are observable and determinable by single analytic techniques or combinations of techniques such as X-ray diffraction, IRRAS, NMR and solvent extraction.

The characteristic poor adhesion of polyimide films has led to the development of numerous methods to modify the polyimide surface to enhance adhesion thereto. Such methods include: coating or co-reacting the polyimide surface with organic adhesion promoting compounds, such as epoxy silane and titanate compounds; swelling the surface with solvents; abrading the surface by mechanical means such as sandblasting; chemical etching; heat treatments such as flame sensitization; vacuum methods such as glow discharge, plasma discharge, sputter etching, ion bombardment, etc.; and irradiation with electron-beam, X-ray, and ultraviolet radiation. These prior art methods suffer one or more of the following deficiencies: 1) material removal causing increased surface roughness, 2) contamination of the polyimide surface with undesirable chemical residues, 3) added process complexity (more process steps), 4) increased process cost, 5) decreased process control, 6) expensive equipment, 7) toxic or corrosive chemical agents, 8) loss of adhesion with time, and 9) minimal increases in adhesion--especially after exposure to high temperatures or acidic plating solutions.

Therefore, the adhesion of surface coatings to, and the integrity of laminates formed from, polyimide substrates remains an unsolved problem in the art. Further improvements in polyimide adhesion are still desired, especially in electronic applications where copper/polyimide laminates are used to make thin, flexible printed circuit boards for mounting microelectronic components. In some PI circuit boards, the copper layer is electroplated directly on the PI substrate. Adhesion problems, especially those occurring in high temperature-humidity environments, and some of the prior art attempts to improve adhesion are described in the background section of U.S. Patent Number 4,975,327. In other PI circuit boards, a layer of adhesive is used to laminate copper foil to the PI substrate. In these circuit boards, the adhesion of the laminating adhesive to the PI substrate becomes a critical factor determining reliability and performance. When high T_{g} epoxy resins, those having a T_{g} greater than 170°C, are used as laminating adhesives with prior art surface treated PI substrates to make circuit boards, the epoxy/PI adhesive bond has low peel adhesion, i.e., less than 105 N/dm.

U.S. Patent No. 3,954,570 describes a process for flame sensitizing PI film using a natural gas flame which improves catalyst receptivity and adhesion of metal to the PI surface. In the disclosed process, the active flame touches the PI surface without affecting its dimensional stability, i.e., the contact time is kept short and the film is not heated to an undesirably high temperature.

U.S. Patent No. 4,152,195 discloses a means of roughening the surface of PI consisting of placing the PI substrate into an oxygen atmosphere and generating electrical discharges which partly burn the surface (col. 2, lines 4-12).

U.S. Patent No. 4,725,504 and European Patent Application No. 281,312 describe laminated products (and a process for making such laminated products) comprised of texturized PI films, an adhesion promoting nickel or cobalt layer, and an electrolytic copper layer. The U.S. patent teaches (col. 5, lines 1-35) that the PI film surface is texturized using a alkaline solution. Such treatment provides a surface which is uniformly and completely frosted and matte with a translucent appearance that is receptive to colloidal catalyzation and the subsequent electroless deposition of an electrically conductive metal layer. However, the original mechanical bulk properties of the film are substantially unaffected by the texturizing process. The topography of the surface is described as characterized by nodules or bumps, rather than pits as reported for other texturizing methods. The peel strength of these laminates exceed 105 N/dm by IPC test 2.4.9 Method A. The peel strengths exceeding 80 N/dm by IPC test 2.4.9 Method C are reported.

Further discussion of alkaline etch surface treatments for polyimide are described by K.W. Lee et al., "Polyimide Surface Chemistry", Polymer Preprints (31), 712-713, (1990) where a 90° peel adhesion of 124 N/dm for a 10 minute treatment with 1 M KOH at 22°C is reported and anonymous Research Disclosure 31579, "Improvement of Polyimide Adhesion by Wet Process" where similar results are reported.

U.S. Patent No. 4,975,327 describes a texturized polyimide sheet or film having surface asperities with discrete metal oxide particles embedded therein, and a process for producing such texturized surfaces by heating and simultaneously oxidizing metallized polyimide.

With the increasing concern over environmental and safety issues, industry has looked toward a number of nonchemical surface modification techniques. Alternative techniques such as treatment with corona, plasma, sputter etch, E-beam, heat, UV, and laser have been used to modify polymer surface properties.

The use of radiation to modify polymer surfaces has been discussed in FN 42214 and other related cases. U.S. Patent Nos. 4,868,006, 4,879,176 and 4,822,451 disclose the formation of quasi-amorphous regions on semicrystalline polymer surfaces by pulsed energy treatment. These patents describe the amorphization of semi-crystalline polymers, such as polyester, by laser irradiation. Commercial polyimide films are not semi-crystalline but ordered amorphous polymers.

U.S. Patent No. 4,879,176 describes semi-crystalline polymers bearing thereon quasi-amorphous surface layers having enhanced bondability to other materials. The disclosure extends to films, coatings, and other polymeric articles having quasi-amorphous surface layers.

U.S. Patent No. 4,822,451 describes an irradiation process for producing quasi-amorphous surface layers on the surface of semi-crystalline polymers.

U.S. Patent No. 4,824,699 describes a process for either washing or recrystallizing the quasi-amorphous surface of semi-crystalline polymers to improve the consistency and strength of bonds between subsequently applied coatings and the polymer surface.

U.S. Patent No. 4,568,632 describes a method for photo etching polyimides using mercury vapor lamps and excimer laser ablation at fluences above the ablation threshold, i.e., greater than 60 mJ/cm²/pulse. However, fluences of at least about 100 mJ/cm²/pulse must be used to produce clean ablative photodecomposition which does not lead to carbonaceous residues, and operative fluences of 300-350 mJ/cm²/pulse appear to be preferred. Ablation degrades the molar mass of the polyimide creating small molecules that vaporize and carry away the absorbed energy. The etched surface produced by photoablative processes does not show the enhanced adhesion produced by the present invention.

Japanese Kokai Patent No. Hei 3[1991]-52936 describes a surface modification method for a polyimide mold, including polyimide films, sheets, and plates, comprising applying an UV region laser beam having a wavelength of less than 400 nm to the surface of the mold. The patent further describes how impurities and moisture existing on the surface of the polyimide mold are optically removed to provide: 1.) a clean surface having improved wettability and 2.) an optically decomposed surface layer containing reactive residual radicals. In the application example, a KrF excimer laser operating at a wavelength of 248 nm and a radiative fluence of approximately 5 mJ/cm²/pulse (calculated) was used to treat the surface of Du Pont KAPTON™ H polyimide film. A copper foil laminate was prepared by the hot press method using a rubber-epoxy-based adhesive. The laminate had a peel strength of 235 N/dm (calculated) when measured using test methods referenced in IPC-FC-241A. The application of 20 pulses (5mJ/cm²/pulse at a wavelength of 248 nm) to the polyimide mold does not, under the described conditions, provide the fluence required to produce the polyimide surface according to the present invention.

The morphology of polyimide has been studied by Wide-Angle X-ray Scattering (WAXS) and Small-Angle X-ray Scattering (SAXS). See for example T.P. Russell, **A Small-Angle X-Ray Scattering Study of an Aromatic Polyimide**, J. Polymer Science (Polymer Physics Ed.) (22), 1105-1117, (1984) and N. Takahashi et al., **Molecular Order in Condensed States of Semiflexible Poly(amic acid) and Polyimide**, Macromolecules (17), 2583-2588, (1984). These studies suggest a complex morphology exhibiting some order but an order that cannot accurately be described as crystalline or semicrystalline. Russell proposes a two-phase model to describe the morphology of polyimide comprising a first phase that is more ordered than the second. The boundary between the two phases is diffuse. Russell uses this model to interpret the results of his X-ray scattering experiments. The ordering is believed to result from an increase in the lateral alignment of the monomer units which can be achieved by only slight longitudinal motions of the bulky polyimide chain segments. Using SAXS Russell shows that ordered phases (also called "aggregates") are statistically distributed within the disordered phase (also called the "non-aggregated region") where the probabilistic average distance between ordered phase regions is in the range of from 60 to 130 angstroms. The actual value of the average distance for any given polyimide specimen is believed to be a function of prior processing conditions (thermal treatment and mechanical orientation, i.e. "stretching") which can cause an increase in size of the ordered aggregates or an increased degree of ordering in the disordered regions between aggregates. Likewise, annealing and imidization are long time, low energy processes which allow the polyimide "system" to reach the thermodynamically preferred lower energy, more oriented state.

Also of interest are P.E. Dyer & J. Sidhu, **Excimer Laser Ablation and Thermal Coupling Efficiency to Polymer Films**, J. Appl. Phys., Vol. 57 (4), 1420-1422, (1985); J.H. Brannon et al., **Excimer Laser Etching of Polyimide**, J. Appl. Phys., Vol. 58 (5), 2036-2043, (1985); and G. Gorodetsky et al., **Calorimetric and Acoustic Study of Ultraviolet Laser Ablation of Polymers**, Appl. Phys. Lett., Vol. 46 (9), 828-830, (1985).

The metallization and wetting properties of polyimide films can be modified by excimer laser treatment at low fluences as described by H. Hiraoka et al., **"Surface Modification of Kapton and Cured Polyimide Films by ArF Excimer Laser: Applications to Imagewise Wetting and Metallization"**, Applied Surface Science (46), 264-271, (1990).

All of these prior art treatments affect polymer surfaces in a fairly gross manner. With the exception of E-beam and heat, each treatment tends to result in a roughened surface caused by removing material, and they all eventually result in chemical modifications to the surface which are much like the changes from wet chemical treatments.

The present invention avoids the problems of damage to, and contamination of, polyimide surfaces by providing a polyimide substrate bearing thereon a disordered amorphous surface layer that provides improved adhesion when said polyimide substrate is used in polymer or metal laminates. The novel adherent surface layer is formed by irradiating an ordered polyimide surface with pulsed, high intensity, high fluence actinic radiation supplied by a UV excimer laser, flashlamp, or ion beam.

Furthermore, the novel disordered amorphous surface provides an advance over prior art surface modification processes because the treated film has good aging properties, no vacuum is required, no contact with the surface is required, no chemistry is added to the treated polymer so that it is more likely to be recyclable, and there are no known environmental problems.

The amorphous layer has a composition unchanged from and identical to that of the ordered amorphous bulk phase but having physical characteristics that are different from that of the bulk phase. The solubility, coefficient of friction, antireflectivity, and anisotropic conductivity are greater and the birefringence, UV dichroism, and density are less in the amorphous layer than in the ordered amorphous bulk polymer. Surprisingly, the modified surfaces of these films have enhanced bondability while the irradiated surface has unchanged texture, visual appearance, and substantially unchanged crosslink density while retaining the chemical properties of bulk polyimide.

Another aspect of the invention provides a process for producing on the surface of a polyimide substrate the inventive disordered amorphous surface layer. The process comprises exposing the surface of an ordered amorphous polyimide to actinic radiation sufficient to rapidly heat a zone of the surface or layer above its glass transition temperature but below its decomposition temperature.

A final aspect of the invention provides laminates useful in making printed circuit boards comprising:
a) copper foil,
b) epoxy adhesive having a T_{g} greater than 170°C, and
c) a polyimide substrate,
said foil having a peel adhesion greater than 105 N/dm when peeled from the laminate as measured by IPC method 2.4.8.1 or 2.4.9.

The invention provides a polyimide substrate bearing thereon a disordered amorphous surface layer that provides improved adhesion when said polyimide substrate is used in polymer or metal laminates, wherein said surface layer is formed by the process of:
a) providing a polyimide substrate having a depth of an ordered amorphous surface zone or layer of polyimide, and
b) irradiating at least a portion of the depth of said ordered amorphous surface layer or zone with radiation from a pulsed energy source that produces pulses of sufficient duration and intensity to heat at least a portion of the depth of said surface layer to a temperature above the glass transition temperature but below the decomposition temperature, thus transforming said layer or zone into an amorphous surface layer,
c) rapidly quenching said amorphous layer to a temperature below the glass transition temperature before the molecules comprising said disordered amorphous surface or zone can reorient to the ordered amorphous state.
An ordered amorphous surface layer is a surface layer comprising diffuse regions of ordered aggregates in a non-aggregated, dis-oriented matrix where the average separation between aggregates occurs on a size scale of generally from 60 to 130 angstroms.

A disordered amorphous surface layer is a surface layer having no ordered regions on a size scale greater than 20 angstroms. The size scale characterizing the separation of the diffuse ordered regions can be quantitatively described by a two-dimensional spatial correlation function which can be derived from the SAXS intensity function as described by Russell (supra).

The disordered surface provides improved adhesion (in the range of 50 to 200 N/dm) when the treated polyimide surface is laminated to other polymers or metals using epoxy laminating adhesives. Commercial polyimide films are ordered amorphous materials that are oriented during manufacture to have improved two-dimensional (in plane) order.

Commercially available polyimides useful in the practice of the invention have the structures I and II below and are sold under the brand names of Kapton™, and Upilex™ respectively. 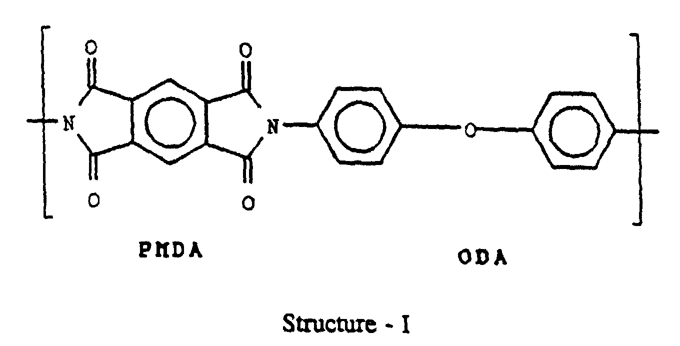 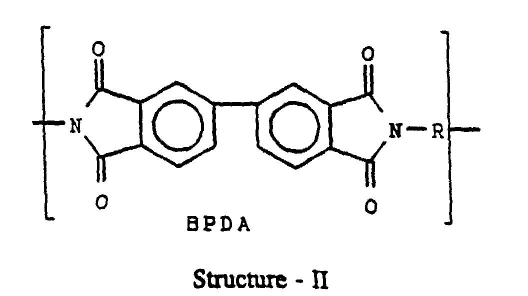 (where R = 4,4'-oxydiphenylene)

Structure I is poly (4,4'-oxydiphenylenepyromellitimide), ), which is the reaction product of pyromellitic dianhydride and 4,4'-diaminodiphenylether and is available as Kapton™ from Du Pont, Wilmington, DE, and as Apical™ from Allied-Signal Corp., Morristown, NJ. It is also made by Kanegafuchi Chemical Industries Co., Ltd., Japan.

Structure II is the reaction product of 3,3',4,4'-biphenyltetracarboxylic acid dianhydride and 4,4'-diaminodiphenylether available as Upilex™ from Ube Chemical Industries, Japan.

All other ordered polyimides are useful in the practice of the invention, and include the reaction product of pyromellitic dianhydride and para-phenylene diamine available as Apical™ NPI from Allied-Signal Corp. and the reaction product of pyromellitic dianhydride and a combination of 4,4'-diaminodiphenylether and 3,3'-dimethylbenzidine, available from Mitsubishi Chemical Industries, Japan. Preferred polyimides are described in Claims 7 and 8. In order to efficiently carry out the process of the present invention, the polyimide must absorb the actinic radiation supplied by the process. Absorption of the radiation may be enhanced by the addition of radiation absorbing dyes and pigments to the polymer. These, and other, radiation absorbing materials can have some noticeable effect at levels as low as 0.05% by weight, but can also be used at higher levels, even up to 90% by weight and higher. For example, a polymer used to modify a pigment may be treated after it has been combined with the pigment. A generally preferred range would be from 0.1 to 50% by weight for such radiation absorbing additives. The wavelength of absorbance of the polyimide plus any optional absorbing dye in the polymer should be in the range of from 1 to 5 µm. The higher the molar absorptivity at any given wavelength, the thinner the layer which dissipates the energy supplied by the actinic radiation and correspondingly, the thinner the disordered amorphous surface layer produced by the process.

There are two necessary conditions required of the actinic radiation source that supplies the energy required to carry out the process of the present invention. Both high intensity (high power per unit area) and high fluence (high energy density per pulse) are required of the radiation source. These conditions assure that the substantial amount of heat generated stays in a very thin layer at the polymer surface. The effect of the radiation is to concentrate energy in the surface layer. Thermal diffusion into the bulk reduces this concentration of energy and makes the process less efficient. It is, therefore, desirable that only a small amount of heat be dissipated into the bulk of the polymer during irradiation. The more heat is transferred to the bulk during the surface irradiation, the less efficient the process becomes until so much heat goes into the bulk that the process no longer works. Therefore, conventional high intensity radiation sources having long pulse widths, such as mercury arc lamps, permit rapid diffusion of the thermal energy into the bulk polymer and are not useful in practicing the present invention. However, the combination of intensity and fluence must not be so great/high as to cause ablation, excessive degradation, or volatilization of polyimide in the surface layer.

The net effects of pulse width, molar absorptivity, and radiation intensity and fluence are to produce particular types of mechanistic events in and among the ordered amorphous polyimide molecules at the substrate surface. First, and to a minor degree, there is a photolytic effect in which absorbed radiation energy causes random bond scission to occur in the oriented amorphous polymer. This effect is desirably minimized in the practice of the present invention to minimize the damage to polymer properties caused by this effect.

The second effect is the thermal excitation of the surface layer. Much of the absorbed light energy is transformed into heat, with the heating portion of the thermal cycle corresponding to the pulse width of the radiation. It is certain that instantaneous temperatures that exceed the normal glass transition temperature of the polymer are reached throughout most of the affected area, although an unusual thermal gradient may be produced within that volume because of the rapid attenuation of the incident energy due to light extinction by the polymer composition. The heating cycle thus corresponds to the pulse width, in a range of from about 10 nanoseconds to 100 microseconds. During the brief time the surface region is heated above T_{g} [its softening temperature], the molecules in ordered aggregates at the polymer surface are able to assume a more random and disordered arrangement, e.g. coordinated molecular motions of the "crankshaft" rotational type cause the bulky polyimide units comprising the ordered aggregates to slip out of lateral alignment and disrupt the packing within the aggregate. Furthermore, while the polyimide surface is above T_{g} the bonds broken during photolysis reconnect, although not necessarily to the same end from which they were broken or to the same degree. The temporarily broken molecular bonds will assist this disordering process. Next the surface layer rapidly cools and "freezes" the new amorphous structure. That is, the cooling rate is fast enough so the surface layer cannot reorient. It is estimated that the surface probably cools below T_{g} in less than a millisecond because of the thin nature of the affected volume and its contact with a suitable cooling fluid, i.e., air or an inert liquid like water, at the surface and bulk material (which are usually at room temperature). Once below this temperature, the polyimide chain conformations are frozen.

The irradiation thus produces an amorphous layer at the surface of the bulk polymer which layer undergoes only a small change in molecular weight because of the recombination of bond scissions. The surface texture undergoes no significant change because no material has been removed or ablated and both heating and cooling occur over a short period of time. Furthermore, the topography of the polymer surface is not modified to any appreciable degree. The physical surface structure, before and after amorphizing, tends to be the same in the practice of the present invention. Surfaces with a high degree of surface roughness may be somewhat softened in their features, but will still tend to have rough surfaces. Smooth surfaces will be substantially unchanged with respect to the absence of features on their surface.

### Flashlamp Sources

When provided by a flashlamp, said pulses typically have a spectral distribution of from 140 to 400 nanometers, a pulse duration of from 0.1 to 100 microseconds, preferably of from 1 to 10 microseconds, and a peak current density of from 2.5 to 25 kiloamperes per square centimeter. A radiative fluence of from 3 to 600 mJ/cm²/pulse, preferably from 15 to 250 mJ/cm²/pulse, is required to form the dis-ordered amorphous layer. The specific fluence required depends on the molar absorptivity of the polyimide and the wavelength range of the flashlamp. Flashlamps suitable for practice of the invention include, but are not limited to, those available from EG&G Inc., Boston, MA or the L-2695 flashlamp available from ILC Technologies Inc., Sunnyvale, CA. New types of flashlamps called flashboards are now becoming commercially available. These flashboards have open emitting systems with no protective cover or flashplate, such as would be used to form an envelope, over the emitting portion of the flashlamp.

### Excimer Laser Sources

When provided by an excimer laser, the energy is supplied on the order of nanoseconds. Therefore lower fluences, in the range of from 15 to 50 mJ/cm²/pulse, are effective of the present invention. However, the mJ/cm²/pulse, are effective for the practice of the present invention. However, the energy supplied should be from 1 to 100% of the ablation threshold energy at the operating wavelength of the laser. The ablation threshold is herein defined as that fluence where over 1 % of the irradiated thickness is etched or vaporized during a single pulse of the laser. The irradiated thickness is herein defined as that thickness having an absorbance of unity. Early investigations of laser treatments of polymers were concerned with etching or ablation of the polymer and thus used laser intensities and fluences much higher than required for the present invention. These investigators found an ablation threshold which was different for each polymer treated. Below this threshold no ablation took place. Investigation was never made to determine what changes in polyimide properties were occurring at lower fluences. It has been found that like the ablation threshold, there is likewise a disordering threshold for the disordering process of this invention and it too varies with the polymer being treated.

For example, the effect of irradiating polyimide with a 248 nanometer KrF excimer laser having a 10 to 20 nanosecond pulse width is not readily discerned at fluences less than 10 mJ/cm²/pulse, as for example at 5 mJ/cm²/pulse. However, at fluences greater than 50 mJ/cm²/pulse, one begins to encounter excessive damage to the affected surface layer, such as vaporization (e.g. off-gassing) of low molecular weight products of photodegradation, substantial reduction of the molecular weight of the surface layer, and more extensive surface roughening.

Excimer lasers suitable for practice of the invention include, but are not limited to the model 202MSC available from Lambda Physik of Acton, MA or the model 2460 available from Questek of Billerica, MA.

### Ion beam Sources

Ion beams suitable for the practice of the invention include, but are not limited to those such as the projected plasma and projected ion sources described in U.S. Patent Application, U.S. Serial No. 07/665,692, filed on March 7, 1991.

The disordered amorphous surface layer produced by the inventive process has the following properties/characteristics. The thickness of the disordered amorphous layer, as measured from the surface downward into the bulk of the polymer, can be controlled. This depth is from 5 nm to 10 µm. Desirably the depth is at least 5 nm, preferably at least 10 nm, or more preferably at least 40 nm and most preferably at least 60 nm.

The surface amorphous layer is firmly adhered to the bulk of the polymer because of the in situ nature of the conversion. There can even be a discernible gradation zone between the amorphous and oriented amorphous areas, although this may not always be the case. That is, the transition can be very abrupt within the polymer.

The portion of the surface area which is amorphized may be as small as 1% with some beneficial effects being noted. Generally it is at least 10%, and preferably 50 to 100% of the surface. More preferably at least 80% to 100% of the surface is amorphous. These are percentages by surface area.

Confirmation that disordering of the oriented amorphous surface does occur is provided by infrared dichroism measurement of the film surface. Oriented polyimide films show an anisotropy with respect to infrared radiation (e.g. between 5,000 and 16,000 nm) in various directions in the film (called dichroism). A reduction in the dichroism between the width and length direction (e.g. the X- and Y-axes) in uniaxially oriented films is observed after irradiation of thin polyimide films and this indicates a loss of orientation of the molecules in the surface layer after irradiation.

The modified surface is preferably substantially free, or even totally free, of polymeric decomposition debris which typically results from ablative processes as described in US Patent No. 4,417,948 and the articles of Dyer & Sidhu, Brannon et al., and Gorodetsky et al. noted above. The presence of such debris can be detected by ellipsometry, microscopy (20,000x), and spectroscopic techniques such as infrared and ESCA which is capable of detecting changes in the oxygen/carbon ratio of the surface material relative to the bulk polyimide.

### Utility

The novel amorphous surface layer on the oriented amorphous polymer base has utility because: (1) it exists without substantial change of the surface chemical structure while the bulk properties of the polymer are unchanged, (2) it has higher toughness than the ordered amorphous surface due to disruption of the in-plane orientation of the molecules, (3) it is more easily swelled by organic solvents which allows a high degree of bond entanglement with itself and with other coatings and polymers, (4) the controlled depth of disorientation or amorphization serves to limit the depth of solvent penetration and hence limits the effect of solvents on the bulk material below the amorphous layer, (5) it has a reduced optical index of refraction which is graded from the bulk to the surface, and (6) it has an indefinite shelf-life. Each of these properties can be very important. For example, film roughness is very injurious in substrates for magnetic media because that roughness can be the limiting factor in the ultimate density of recorded information that can be achieved. Finally, the absence of a major fraction of low molecular weight oligomeric products in the surface amorphous layer avoids the situation where subsequently applied functional coatings fail in use due to inherently poor adhesion or solvent resistance which stems from the weak boundary layer present at the coating/film interface.

The polymers having the amorphous surface produced according to the present invention can be used in product areas where those polymers have previously been used. For example, polyimide film is used extensively as a dielectric substrate for the construction of flexible, multilayer flexible and rigid-flex circuit boards. The one or two side adhesive coated polyimide film is laminated (using heat and pressure) with foil to form a copper clad laminate. An especially preferred adhesive for forming the laminate is a high T_{g} epoxy adhesive cured using a curing agent derived from 9,9-bis(aminophenyl)fluorenes as disclosed in U.S. Patent No. 4,684,678 hereby incorporated for reference. The copper clad laminate is then imaged and etched to form a circuit pattern on the polyimide dielectric. Single-side adhesive coated polyimide film (having no copper) serves as a cover layer which can be laminated over the etched circuitry. Adhesion of the copper and adhesive of the cover layer are very important in determining the reliability and failure rate of the finished circuits because these circuits are subjected to heat and vibration causing delamination resulting in failure of the circuit.

From the above description, it can be seen that the scope of the present application comprises a polyimide substrate according to claims 1 to 9, a laminate according to claims 10 and 11, a printed circuit board according to claim 12, a polyimide layer according to claims 13 to 16 and a process according to claim 17.

Furthermore, the scope of the present application comprisesa polyimide according to anyone of claims 1 to 10 having an epoxy adhesive coating on at least one surface, said at least one surface bearing thereon a disordered amorphous surface layer of polyimide.

### Preparation and Testing of Laminates

In order to demonstrate that the radiation induced amorphous surface layer affects the adhesion of laminates, laminated film specimens were prepared for 90° peel testing using the following procedure.

### Applying a Curable Epoxy Adhesive Coating

a) coating the film with an epoxy adhesive by dipping the film in a tank containing a dispersion of fluorene epoxy adhesive (as produced and described in U.S. Patent No. 4,684,678) in 1,2-dichloroethane,
b) drawing the film vertically through a pair of No. 37 Meyer bars to form a uniform coating,
c) - drying the coatings at room temperature for 30 minutes followed by drying at 50°C for 2 additional minutes to provide a 25 µm thick dried adhesive coating on both sides of test specimen,

### Forming a Laminate

d) laminating sheets of Yates 1 oz. TWI zinc treated copper foil to both sides of the test specimen as follows:
i) A (12.5 cm x 12.5 cm) square of adhesive coated film is placed between two square (15 cm x 15 cm) sheets of copper foil with the zinc treated side of the foil facing the uncured epoxy adhesive,
ii) Placing this sandwich between caul plates and pressing the resulting stack in a hydraulic press. Optimum peel results are obtained when the thickness of the adhesive layers is greater than 15 µm. [The average adhesive thickness is most accurately monitored by weight, i.e., maintaining the resin content to between 50 to 55 % resin content after lamination where: resin content = wt epoxy resin/(wt epoxy resin + wt of film specimen)]. Before applying pressure the stack is heated at a rate of 5°C/min to the cure temperature of 177°C and held at the cure temperature for between 0 to 18 minutes to obtain specimens with the proper adhesive thickness. The pressure is then raised to 345 kPa (50 psi) and curing continued for an additional 75 minutes at 177°C after which the pressure is released and the stack cooled to room temperature,
iii) Optionally post curing the specimens by placing the stack in a convection oven at 202°C for 1 hour with no applied pressure,
iv) Trimming the laminate to a rectangle (7.0 2 cm x 5.7 cm) using a paper cutter,

### Etching the Laminate

e) etching the laminate rectangle to form stripes (7.0 cm x 0.3 cm) for peel testing by:
i) cleaning the surface by scrubbing with a Scotch Brite abrasive pad followed by a one minute dip in 5 M aqueous sulfuric acid and deionized water rinse
ii) masking the areas of the surface to be protected from etching by applying 0.3 cm wide strips of 3M brand No. 218 fine line masking tape,
iii) etching the unmasked copper regions according to The Institute of Printed Circuitry (IPC) test method 2.3.7.1 by immersing the laminate in aqueous 10 M ferric chloride solution (E-4G ferric chloride etching solution available from Kepro) maintained at a temperature of less than 45°C. Etch time is approximately 15 minutes but is adjusted to avoid over etching or undercutting of the masked copper area. Upon removal from the etch bath, the specimen is repeatedly rinsed with distilled water and dried at room temperature.

### Measuring the 90° Peel Adhesion

The 90° peel adhesion is measured according to IPC-TM-650 method 2.4.8.1 using a Sintech tensile tester equipped with a 22.7 kg load cell and sliding plate test fixture which maintains the peel angle at 90°. The peel rate is 5 cm/min and the peel value is averaged over a peel length of 5 cm. The reported peel adhesion (and accompanying standard deviation) is the average of 5 tests.

### Examples

### EXAMPLE - 1, Effect of UV Laser Treatment

Both surfaces of the indicated PI films (2m x 15cm x 25 µm) were uniformly irradiated using a Lambda Physik 202MSC excimer laser operating at 248 nm. A fluence of 29 mJ/cm²/pulse with a 20-40% areal overlap was used. Copper foil laminates were prepared and tested as described above. Test results are shown in Table I, where n=5 for all samples (n being the number of specimens tested).

**TABLE - I**

| Film Type | Average Peel | | Average SD | |
|---|---|---|---|---|
| | (lb/in) | (N/dm) | (lb/in) | (N/dm) |
| Apical 25 AH | | | | |
| treated | 9.79 | 171.52 | 0.25 | 4.38 |
| untreated | 3.98 | 69.73 | 0.59 | 10.34 |

| UBE S | | | | |
|---|---|---|---|---|
| treated | 6.25 | 109.50 | 1.03 | 18.05 |
| untreated | 4.31 | 75.51 | 0.74 | 12.96 |

| Kapton 100 H | | | | |
|---|---|---|---|---|
| treated | 8.49 | 148.74 | 0.17 | 2.98 |
| untreated | 2.66 | 46.60 | 0.97 | 16.99 |

| Kapton 100 V | | | | |
|---|---|---|---|---|
| treated | 9.76 | 171.00 | 0.11 | 1.93 |
| untreated | 4.08 | 71.48 | 0.63 | 11.04 |

X-ray photoelectron spectroscopy (XPS) was performed on the treated and untreated film surfaces and the fracture surfaces produced during peel testing. Analysis of the laser treated film surface showed essentially constant levels of nitrogen, oxygen, and carbon for all laser fluences up to 25 mJ/cm² indicating that laser treatment does not oxidize or reduce the polyimide surface. After the peel test, analysis of the fracture surface of the copper strip from the untreated PI shows essentially the same chemical composition as the untreated and unlaminated PI film surface. No copper or chlorine (from the epoxy laminating adhesive) was seen, indicating cohesive failure within the polyimide and transfer of an exfoliation layer to the copper strip. Analysis of the peel strip from the laser treated surface showed the presence of zinc (from the zinc treated surface of the copper foil) and chlorine in addition to carbon and oxygen, indicating failure at the epoxy/copper foil interface. Measurements of the changes in reflectivity and infrared dichroism of laser treated surfaces are consistent with a disordering of the polymer surface accompanying transition from the ordered amorphous to the amorphous state.

### EXAMPLE - 2, Effect of flashlamp Treatment

Kapton™ 100 XFPC film available from Du Pont was exposed to radiation from a flashlamp (30 cm arc length, 200 torr xenon fill pressure, 4 millimeter bore lamp housed in a 10 cm aperture parabolic reflector with a SiO₂/Aluminum reflective coating, pulsed by capacitive discharges of 81 and 100 Joules respectively, at a frequency of 5 Hz, and a pulse width of 6 microseconds with a 1.5 ampere simmer current). The web speed through the treater was 15 meters/minute. The samples were laminated and tested as described above with the following exceptions:
a) During lamination pressure was applied after 17 minutes to obtain a bond thickness greater than 15 micrometers.
b) Peel testing was performed with a CECO Copper Clad Peel Tester model TA-630 with a 1 kg load cell using IPC-TM-650 method 2.4.9.
c) Only three specimens were tested.
d) Untreated film surfaces were laminated and tested as controls

Test results are shown in Table II, with n=3.

**TABLE - II**

| Experiment 2 | | | | |
|---|---|---|---|---|
| Solution Epoxy Adhesion to Flashlamp Treated Kapton 100 XFPC | | | | |
| Treatment Level | Average Peel | | Average SD | |
| (Joules) | (lb/in) | (N/dm) | (lb/in) | (N/dm) |
| Untreated | 1.66 | 29.08 | 1.09 | 19.10 |
| 81 | 7.81 | 136.83 | 1.10 | 19.27 |
| 100 | 7.25 | 127.02 | 0.59 | 10.34 |

The test data shows significant improvement in adhesion for flashlamp treated films.

### EXAMPLE - 3, Adhesion as a Function of UV Laser Fluence

Kapton™ 100XFPC film was laser treated as in Example 1 at fluences of 17, 20, 23, 26, 28, 32, and 35 mJ/cm²/pulse, laminated as described above, and tested using the procedure of Example 2. Test results are shown in Table III.

**TABLE - III**

| Experiment 3 | | | | | |
|---|---|---|---|---|---|
| Solution Epoxy Adhesion to Laser Treated Polyimide (Kapton XFPC) | | | | | |
| Treatment Level | | Average Peel | | Average SD | |
| (mJ/cm²) | | (lb/in) | (N/dm) | (lb/in) | (N/dm) |
| n=21 | Untreated | 3.21 | 56.24 | 1.12 | 19.62 |
| n=3 | 17 | 4.89 | 85.67 | 1.67 | 29.26 |
| n=3 | 20 | 6.51 | 114.06 | 1.12 | 19.62 |
| n=3 | 23 | 9.44 | 165.39 | 0.17 | 2.98 |
| n=3 | 26 | 9.40 | 164.69 | 0.18 | 3.15 |
| n=3 | 29 | 9.38 | 164.34 | 0.23 | 4.03 |
| n=3 | 32 | 8.57 | 150.15 | 0.14 | 2.45 |
| n=3 | 35 | 6.18 | 108.27 | 2.89 | 50.63 |

wherein n is the number of specimens tested in determining the average and standard deviation.

The results show that the peel adhesion rises to approximately a constant value of about 165 N/dm and then decreases due to photoablation of the polyimide.

### EXAMPLE - 4, Adhesion as a Function of Flashlamp Voltage

Kapton™ 100V film available from Du Pont was flashlamp treated following the procedure of Example 2 using capacitive discharges of 64, 72, 81, 90, and 100 Joules to vary the level of UV exposure. The samples were laminated and tested as in Example 2. Test results are shown in Table IV, with n=3.

**TABLE - IV**

| Experiment 4 | | | | |
|---|---|---|---|---|
| Solution Epoxy Adhesion to Flashlamp Treated polyimide (Kapton 100V) | | | | |
| Treatment Level | Average Peel | | Average SD | |
| (Joules) | (lb/in) | (N/dm) | (lb/in) | (N/dm) |
| Untreated | 1.80 | 31.54 | 0.58 | 10.16 |
| 64 | 8.04 | 140.86 | 0.94 | 16.47 |
| 72 | 6.61 | 115.81 | 1.40 | 24.53 |
| 81 | 5.57 | 97.59 | 1.27 | 22.25 |
| 90 | 8.42 | 147.52 | 1.17 | 20.50 |
| 100 | 7.96 | 139.46 | 1.28 | 22.43 |

The results show improvement in adhesion, somewhat independent of the discharge energy used.

### EXAMPLE - 5, Adhesion of Cast Polyimide to UV Laser Treated Film

A 200 µm thick film of polyamic acid solution (RC-5019 available from Du Pont) was cast on the treated films of Example 6 and cured to form a 25 µm thick cast polyimide film. The cast laminate was tested using the procedure of Example 2 except the test strips were 2.5 cm wide and a razor blade was used to initiate peeling of the laminate. Above a treatment level of 15 mJ/cm² the cast film tore rather than peeled from the treated film substrate indicating a peel strength greater than the tear strength of the cast film. The test results are shown in Table V, with n=2.

**TABLE - V**

| Experiment 5 | | | | |
|---|---|---|---|---|
| Solvent Cast Polyimide Adhesion to Laser Treated Polyimide Films | | | | |
| Treatment Level | Average Peel | | Average SD | |
| (mJ/cm²) | (lb/in) | (N/dm) | (lb/in) | (N/dm) |
| Untreated | 0.22 | 3.89 | 0.02 | 0.39 |
| 5 | 0.34 | 5.99 | 0.03 | 0.60 |
| 10 | 0.47 | 8.23 | 0.17 | 2.98 |
| 15 | 0.47 | 8.30 | 0.04 | 0.74 |

The results show dramatic increases in adhesion with laser fluences exceeding 10 mJ/cm²/pulse,

### Example - 6, Adhesion of Urethane Adhesive to UV Laser Treated Film

Kapton™ 100V film was laser treated at the indicated fluences and coated with a 100 micrometer thick layer of a polyurethane heat sealable adhesive having the following composition:

| Ingredient | Wt % | Mole % |
|---|---|---|
| poly(tetramethyleneoxide)(PTMO -650) | 43.76 | 19.57 |
| butanediol | 9.35 | 29.93 |
| H12-methylenediisocycanate | 45.85 | 50.5 |
| Tinuvin™ 700 | 4.09 | |
| Tinuvin™ 328 | 4.09 | |
| dibutyl di-tin laurate | 0.5 | |

This adhesive was used to prepare test specimens by folding the treated film surface over on itself, inserting a 2.5 to 5.0 cm wide by 15 cm long strip of adhesive and heat scaling the resulting sandwich at 230°C at 380 kPa for 10 seconds. The sealed test specimen was cut with a paper cutter into 2.5 cm wide strips. The peel resistance of these strips was measured by a T-peel test (ASTM D 1876-72) using a Sintech tensile tester having a 25 Lb. (12.5 kg.) load cell. The free ends of the sample were clamped in the jaws and the jaws were separated at 1 inch/minute (2.54 cm./min).

In this T-peel test there is an initial force (peak force) required to initiated the continuous peeling. Both the average peak force and average continuous peel values (n=5) are shown in Table VI to demonstrate the improvement in adhesion with treatment level.

**TABLE - VI**

| Experiment 6 | | | | |
|---|---|---|---|---|
| 100% Solids Polyurethane Adhesion to Laser Treated Polyimide | | | | |
| Treatment Level | Average Peel | | Average SD | |
| (nd/cm²) | (lb/in) | (N/dm) | (lb/in) | (N/dm) |
| Untreated | 0.20 | 3.50 | 0.10 | 1.75 |
| 5 | 0.20 | 3.50 | 0.20 | 3.50 |
| 10 | 0.30 | 5.26 | 0.00 | 0.00 |
| 15 | 0.40 | 7.01 | 0.10 | 1.75 |
| 20 | 3.30 | 57.82 | 0.20 | 3.50 |
| 25 | 1.20 | 21.02 | 0.20 | 3.50 |
| 30 | 1.40 | 24.53 | 0.30 | 5.26 |
| 40 | 2.70 | 47.30 | 1.30 | 22.78 |
| 50 | 1.80 | 31.54 | 1.10 | 19.27 |
| Untreated | 0.50 | 8.76 | 0.10 | 1.75 |
| 5 | 0.40 | 7.01 | 0.40 | 7.01 |
| 10 | 1.20 | 22.78 | 0.60 | 10.51 |
| 15 | 1.30 | 22.78 | 0.40 | 7.01 |
| 20 | 4.60 | 80.59 | 0.30 | 5.26 |
| 25 | 3.00 | 52.56 | 0.50 | 8.76 |
| 30 | 3.70 | 64.82 | 0.80 | 14.02 |
| 40 | 4.30 | 75.34 | 1.10 | 19.27 |
| 50 | 3.40 | 59.57 | 0.90 | 15.77 |

The results show that laser treatment dramatically improves adhesion especially above 15 mJ/cm².

### Example - 7, Adhesion of Hot Melt Epoxy Adhesive Copper Foil Laminates

Kapton™ 100V films were laser treated according to the procedure of Example 1. Test specimens were made with the epoxy adhesive (as produced and described in U.S. Patent No. 4,684,678) by coating the (100% solids) adhesive onto a release film using a heated three roll coater. The epoxy film was coated to a thickness of 25 µm. The epoxy film was transferred to the treated Kapton™ film using a flat hand iron (Black and Decker) heated to 95°C (permanent press setting). Copper foil was laminated to the specimens using the procedure described in Example 1 and tested according to the procedure of Example 2 with the following exception. The laminating press was preheated to 177°C. The test results are shown in Table VII.

**TABLE VII**

| 100% Solids Epoxy Adhesion | | | | | |
|---|---|---|---|---|---|
| Treatment Level | | Average Peel | | Average SD | |
| (mJ/cm²) | | (lb/in) | (N/dm) | (lb/in) | (N/dm) |
| n=1 | Untreated | 3.56 | 62.37 | 0.34 | 5.96 |
| n=5 | 5 | 3.89 | 68.15 | 0.76 | 13.32 |
| n=5 | 10 | 2.72 | 47.65 | 0.22 | 3.85 |
| n=5 | 15 | 4.96 | 86.90 | 0.31 | 5.43 |
| n=5 | 20 | 7.78 | 136.31 | 0.29 | 5.08 |
| n=5 | 25 | 9.30 | 162.94 | 0.10 | 1.75 |
| n=5 | 30 | 7.75 | 135.78 | 0.58 | 10.16 |
| n=5 | 40 | 8.55 | 149.80 | 0.49 | 8.58 |
| n=5 | 50 | 9.86 | 172.75 | 0.21 | 3.68 |

The results show that adhesion improves between exposures of 15 to 20 mJ/cm²/pulse with acceptable adhesion at any level above 20 mJ/cm²/pulse.

### Example - 8, Adhesion of Acrylic Adhesive to UV Treated Polyimide

Kapton™ 100V films were laser treated according to the procedure of Example 6 and laminated to PyraluxLF-0110 (available from Du Pont), which is a 25 µm thick layer of acrylic adhesive bonded to 25 µm thick Kapton film. Lamination to the treated film was done on 12.5 cm square pieces at 204°C under 345 kPa pressure for 30 minutes. Poly(vinylfluoride) release film was inserted at one edge of the square so that peel could be initiated. Test specimens were prepared by trimming the laminate to 2.5 cm wide strips. The specimens were tested using the T-peel test method of Example 6. Specimens with treatment greater or equal to 20 mJ/cm²/pulse would tear after some portion of peeling. The number of samples torn as a function of fluence is included with the test results shown in Table VIII.

**TABLE - VIII**

| **SAMPLE** | **TEARS OUT OF 5 SAMPLES** | | | |
|---|---|---|---|---|
| Untreated | 0 | | | |
| 10 | 0 | | | |
| 20 | 2 | | | |
| 30 | 2 | | | |
| 40 | 4 | | | |
| 50 | 5 | | | |

| Experiment 8 | | | | |
|---|---|---|---|---|
| 100% Solids Acrylic - Pyralux® | | | | |
| Treatment Level | Average Peak | | Average SD | |
| (mJ/cm²) | (lb/in) | (N/dm) | (lb/in) | (N/dm) |
| Untreated | 1.3 | 22.78 | 0.2 | 3.50 |
| 10 | 2.3 | 40.30 | 1.4 | 24.53 |
| 20 | 3.2 | 56.06 | 0.8 | 14.02 |
| 30 | 3.4 | 59.57 | 2.0 | 35.04 |
| 40 | 4.1 | 71.83 | 0.7 | 12.26 |
| 50 | 5.5 | 96.36 | 0.2 | 3.50 |
| | | | | |

| Experiment 8 | | | | |
|---|---|---|---|---|
| 100% Solids Acrylic (Pyralux®) | | | | |
| Treatment Level | Average Peel | | Average SD | |
| (mJ/cm²) | (lb/in) | (N/dm) | (lb/in) | (N/dm) |
| Untreated | 0.90 | 15.77 | 0.10 | 1.75 |
| 10 | 1.70 | 29.78 | 0.20 | 3.50 |
| 20 | 1.50 | 26.28 | 0.70 | 12.26 |
| 30 | 1.70 | 29.78 | 0.10 | 1.75 |
| 40 | 1.90 | 33.29 | 0.00 | 0.00 |
| 50 | 2.60 | 45.55 | 1.00 | 17.52 |

### EXAMPLE 9

### Adhesion as a Function of Time.

Kapton™ 100 XFPC film was laser treated according to the procedure in Example 1 at a fluence of 26 mJ/cm²/pulse. Two test specimens were made with the epoxy adhesive (as produced and described in U.S. Patent No. 4,674,678) by coating the (100% solids) adhesive onto a release film using a heated three roll coater. The epoxy film was coated to a thickness of 35µm. The epoxy film was transferred to the treated Kapton™ film using an automated lamination machine (a procedure well known by those skilled in the art). Copper foil was laminated to the specimens using the procedure described in Example 1. Peel measurements were made using the method of Example 2.

Specimen #1 was laminated 7 months after laser treatment of the Kapton™ film and 3.5 months after coating of the epoxy adhesive onto this film. Specimen #2 was coated and laminated 14.5 months after laser treatment of the Kapton™ film. The test results are shown in Table IX, the average peels were obtained from three peel strips (n=3).

**TABLE IX**

| Experiment 9 | | | | | |
|---|---|---|---|---|---|
| 100% Solids Epoxy Adhesive | | | | | |
| Kapton™ XFPC Film Laser Treated at 26 mJ/cm²/pulse | | | | | |
| | Time Since Film | Average Peel | | Average SD | |
| | Treatment (months) | (lb/in) | (N/dm) | (lb/in) | (N/dm) |
| Sample 1 | 7 | 9.38 | 164.35 | 0.21 | 3.67 |
| Sample 2 | 14.5 | 9.46 | 165.76 | 0.12 | 2.10 |

These results show that the improved adhesion arising from the laser treatment is long lasting and shows no degradation in adhesion which is typical of other surface treatment methods.

## Claims

1. A polyimide substrate bearing thereon a disordered amorphous surface layer that provides improved adhesion when said polyimide substrate is used in polymer or metal laminates, wherein said surface layer is formed by the process of:
a) providing a polyimide substrate having an ordered amorphous surface layer with a depth thereto ordered meaning regions of ordered aggregates in a non-aggregated matrix where the average separation between aggregat occurs on a size scale of from 60 to 130 Angstroms, and
b) irradiating at least a portion of said depth with radiation from a pulsed energy source that produces pulses of sufficient duration and intensity to heat said at least a portion of said depth to a temperature above the glass transition temperature but below the decomposition temperature, thus transforming said at least a portion of said depth into a disordered amorphous surface layer, disordered meaning no ordered regions on a size scale greater than 20 Angstroms
c) rapidly quenching said amorphous layer to a temperature below the glass transition temperature before the molecules comprising said disordered amorphous surface can reorient to the ordered amorphous state.

2. The substrate of claim 1, wherein said pulsed energy source is a flashlamp having a spectral distribution of from 140 to 400 nanometers, a pulse duration of from 0.1 to 100 microseconds, and a current density of from 2.5 to 25 kiloamperes per square centimeter.

3. The substrate of claim 1, wherein said pulsed energy source is an ion beam.

4. The substrate of Claim 1, wherein said pulsed energy source is an excimer laser.

5. The substrate of anyone of Claims 1 to 4, wherein the thickness of said amorphous surface layer is from 5 nanometers to 10 micrometers.

6. The substrate of anyone of Claims 1 to 5, wherein said polyimide has a Tg in the range of from 200°C to 600°C.

7. The substrate of Claim 6 wherein said polyimide is selected from the group consisting of poly(4,4'-oxydiphenylenepyromellitimide), poly(4,4'-iminodiphenylenepyromellitimide), poly(4,4'-diphenylenepyromellitimide), poly(4,4'-di(3,3'-dimethyl)diphenylenepyromellitimide), poly(4,4'-oxydiphenylene-4,4' '3,3,-biphenyldiimide), and copolymers thereof.

8. The substrate of anyone of Claims 1 to 7, wherein the peel adhesion of an epoxy/copper foil laminate to said amorphous layer exceeds 105 N/dm.

9. The substrate of anyone of Claims 1 to 8, wherein said substrate is a film.

10. A laminate comprising:
a) copper foil,
b) epoxy adhesive having a T_{g} greater than 170°C, and
c) a polyimide substrate according to anyone of Claims 1 to 9 said foil having a peel adhesion greater than 105 N/dm when peeled from the laminate as measured by IPC test method 2.4.8.1.

11. The laminate of claim 10, wherein the epoxy adhesive is a fluorene epoxy adhesive.

12. A printed circuit board comprising the laminate of Claim 10 or 11.

13. A polyimide layer having ordered amorphous polyimide with a surface comprising disordered amorphous polyimide.

14. The layer of Claim 13 wherein said polyimide has a Tg in the range of from 200°C to 600°C.

15. The layer of Claim 13 or 14, wherein said polyimide is selected from the group consisting of poly(4,4'-oxydiphenylenepyromellitimide), poly(4,4'-iminodiphenylenepyromellitimide), poly(4,4'-diphenylenepyromellitimide), poly(4,4'-di(3,3'-dimethyl)diphenylenepyromellitimide), poly(4,4'-oxydiphenylene-4,4',3,3'-biphenyldiimide), and copolymers thereof.

16. The layer of anyone of Claims 13 to 15 adhered to the epoxy of an epoxy/copper foil laminate, wherein the peel adhesion of an epoxy/copper foil laminate to said amorphous layer exceeds 105 N/dm.

17. A process for improving a polyimide substrate comprising
a) providing a polyimide substrate having an ordered amorphous surface layer with a depth thereto ordered meaning regions of ordered aggregates in a non-aggregated matrix where the average separation between aggregat occurs on a size scale of from 60 to 130 Angstroms, and
b) irradiating at least a portion of said depth with radiation from a pulsed energy source that produces pulses of sufficient duration and intensity to heat said at least a portion of said depth to a temperature above the glass transition temperature but below the decomposition temperature, thus transforming said at least a portion of said depth into a disordered amorphous surface layer, disordered meaning no ordered regions on a size scale greater than 20 Angstroms
c) rapidly quenching said amorphous layer to a temperature below the glass transition temperature before the molecules comprising said disordered amorphous surface can reorient to the ordered amorphous state.

## Patentansprüche

1. Polyimidsubstrat, das darauf eine ungeordnete amorphe Oberflächenschicht trägt, die eine verbesserte Adhäsion bewirkt, wenn das Polyimidsubstrat in Polymer- oder Metallaminaten verwendet wird, wobei die Oberflächenschicht mit dem folgenden Verfahren erzeugt wird:
a) Bereitstellen eines Polyimidsubstrates mit einer geordneten amorphen Oberflächenschicht mit einer Tiefe, wobei geordnet Bereiche von geordneten Aggregaten in einer nicht-aggregierten Matrix bedeutet, in der der mittlere Abstand zwischen den Aggregaten auf einer Größenskala von 60 bis 130 Angström liegt, und
b) Bestrahlen wenigstens eines Teils der Tiefe mit Strahlung einer gepulsten Energiequelle, die Pulse genügender Dauer und Intensität erzeugt, um wenigstens einen Teil der Tiefe auf eine Temperatur oberhalb der Glasübergangstemperatur, aber unterhalb der Zersetzungstemperatur zu erhitzen und so wenigstens einen Teil der Tiefe in eine ungeordnete amorphe Oberflächenschicht zu transformieren, wobei ungeordnet keine geordneten Bereiche auf einer Größenskala von mehr als 20 Angström bedeutet,
c) Schnelles Abkühlen der amorphen Schicht auf eine Temperatur unterhalb der Glasübergangstemperatur, bevor die Moleküle, die die ungeordnete amorphe Oberfläche ausmachen, sich in den geordneten amorphen Zustand zurück orientieren können.

2. Substrat gemäß Anspruch 1, wobei die gepulste Energiequelle eine Blitzlampe mit einer Spektralverteilung von 140 bis 400 Nanometern, einer Pulsdauer von 0.1 bis 100 Mikrosekunden und einer Stromdichte von 2.5 bis 25 Kiloampere pro Quadratzentimeter ist.

3. Substrat gemäß Anspruch 1, wobei die gepulste Energiequelle ein Ionenstrahl ist.

4. Substrat gemäß Anspruch 1, wobei die gepulste Energiequelle ein Excimerlaser ist.

5. Substrat gemäß einem beliebigen der Ansprüche 1 bis 4, wobei die Dicke der amorphen Oberflächenschicht 5 Nanometer bis 10 Mikrometer beträgt.

6. Substrat gemäß einem beliebigen der Ansprüche 1 bis 5, wobei das Polyimid eine Tg im Bereich von 200°C bis 600°C hat.

7. Substrat gemäß Anspruch 6, wobei das Polyimid aus Poly(4,4'-oxydiphenylenpyromellithimid), Poly(4,4'-iminodiphenylenpyromellithimid), Poly(4,4'-diphenylenpyromellithimid), Poly(4,4'-di(3,3'-dimethyl)diphenylenpyromellithimid), Poly(4,4'-oxydiphenylen-4,4',3,3'-biphenyldiimid) und Copolymeren davon ausgewählt ist.

8. Substrat gemäß einem beliebigen der Ansprüche 1 bis 7, wobei die Schälfestigkeit eines Epoxid/Kupferfolienlaminates mit der amorphen Schicht 105 N/dm übersteigt.

9. Substrat gemäß einem beliebigen der Ansprüche 1 bis 8, wobei das Substrat ein Film ist.

10. Laminat umfassend:
a) Kupferfolie,
b) Epoxidklebstoffmit einer Tg von mehr als 170°C, und
c) Polyimidsubstrat gemäß einem beliebigen der Ansprüche 1 bis 9,
wobei die Folie eine Schälfestigkeit von mehr als 105 N/dm, gemessen mit dem IPC-Testverfahren 2.4.8.1, aufweist, wenn sie von dem Laminat abgeschält wird.

11. Laminat gemäß Anspruch 10, wobei der Epoxidklebstoff ein Fluorenepoxidklebstoff ist.

12. Leiterplatte, umfassend das Laminat gemäß Anspruch 10 oder 11.

13. Polyimidschicht mit geordnetem amorphem Polyimid mit einer Oberfläche, die ungeordnetes amorphes Polyimid umfaßt.

14. Schicht gemäß Anspruch 13, wobei das Polyimid eine Tg im Bereich von 200°C bis 600°C hat.

15. Schicht gemäß Anspruch 13 oder 14, wobei das Polyimid aus Poly(4,4'-oxydiphenylenpyromellithimid), Poly(4,4'-iminodiphenylenpyromellithimid), Poly(4,4'-diphenylenpyromellithimid), Poly(4,4'-di(3,3'-dimethyl)diphenylenpyromellithimid), Poly(4,4'-oxydiphenylen-4,4',3,3'-biphenyldiimid) und Copolymeren davon ausgewählt ist.

16. Schicht gemäß einem beliebigen der Ansprüche 13 bis 15, anhaftend an das Epoxid eines Epoxid/Kupferfolienlaminates, wobei die Schälfestigkeit eines Epoxid/Kupferfolienlaminates mit der amorphen Schicht 105 N/dm übersteigt.

17. Verfahren zur Verbesserung eines Polyimidsubstrates, umfassend :
a) Bereitstellen eines Polyimidsubstrates mit einer geordneten amorphen Oberflächenschicht einer Tiefe, wobei geordnet Bereiche von geordneten Aggregaten in einer nicht-aggregierten Matrix bedeutet, in der der mittlere Abstand zwischen den Aggregaten auf einer Größenskala von 60 bis 130 Angström liegt, und
b) Bestrahlen wenigstens eines Teils der Tiefe mit der Strahlung einer gepulsten Energiequelle, die Pulse genügender Dauer und Intensität erzeugt, um wenigstens einen Teil der Tiefe auf eine Temperatur oberhalb der Glasübergangstemperatur, aber unterhalb der Zersetzungstemperatur zu erhitzen und so wenigstens einen Teil der Tiefe in eine ungeordnete amorphe Oberflächenschicht zu transformieren, wobei ungeordnet keine geordneten Bereiche auf einer Größenskala von mehr als 20 Angström bedeutet,
c) Schnelles Abkühlen der amorphen Schicht auf eine Temperatur unterhalb der Glasübergangstemperatur, bevor die Moleküle, die die ungeordnete amorphe Oberfläche ausmachen, sich in den geordneten amorphen Zustand zurück orientieren können.

## Revendications

1. Substrat de polyimide comportant une couche superficielle amorphe désordonnée qui confère une adhérence améliorée lorsque ledit substrat de polyimide est utilisé dans des stratifiés de polymère ou métalliques, dans lequel ladite couche superficielle est formée par le procédé :
a) de formation d'un substrat de polyimide comportant une couche superficielle amorphe ordonnée d'une certaine épaisseur, ordonnée désignant des régions d'agrégats ordonnés dans une matrice non agrégée où la séparation moyenne entre agrégats se produit à une échelle de grandeur allant de 60 à 130 Angströms, et
b) d'irradiation d'au moins une partie de ladite épaisseur avec un rayonnement provenant d'une source d'énergie pulsée qui produit des impulsions de durée et d'intensité suffisantes pour chauffer au moins cette partie de ladite épaisseur à une température au-dessus de la température de transition vitreuse mais en dessous de la température de décomposition, en transformant ainsi au moins cette partie de ladite épaisseur en une couche superficielle amorphe désordonnée, désordonnée signifiant qu'il n'y a pas de régions ordonnées à une échelle de grandeur supérieure à 20 Angströms,
c) de refroidissement rapide de ladite couche amorphe à une température en dessous de la température de transition vitreuse avant que les molécules comprenant ladite surface amorphe désordonnée puissent se réorienter à l'état amorphe ordonné.

2. Substrat suivant la revendication 1, dans lequel ladite source d'énergie pulsée est une lampe flash ayant une distribution spectrale de 140 à 400 nanomètres, une durée d'impulsion de 0,1 à 100 microsecondes et une densité de courant de 2,5 à 25 kiloampères par centimètre carré.

3. Substrat suivant la revendication 1, dans lequel la source d'énergie pulsée est un faisceau ionique.

4. Substrat suivant la revendication 1, dans lequel ladite source d'énergie pulsée est un laser excimère.

5. Substrat suivant l'une quelconque des revendications 1 à 4, dans lequel l'épaisseur de la couche superficielle amorphe est de 5 nanomètres à 10 micromètres.

6. Substrat suivant l'une quelconque des revendications 1 à 5, dans lequel le polyimide a une Tg dans l'intervalle de 200°C à 600°C.

7. Substrat suivant la revendication 6, dans lequel le polyimide est choisi dans le groupe comprenant le poly(4,4'-oxydiphénylènepyromellitimide), le poly(4,4'-iminodiphénylènepyromellitimide), le poly(4,4'-diphénylènepyromellitimide), le poly(4,4'-di(3,3'-diméthyl)diphénylènepyromellitimide), le poly(4,4'-oxydiphénylène-4,4',3,3'-biphényldiimide) et leurs copolymères.

8. Substrat suivant l'une quelconque des revendications 1 à 7, dans lequel l'adhérence au pelage d'un stratifié d'époxy/feuille de cuivre à la couche amorphe précitée excède 105 N/dm.

9. Substrat suivant l'une quelconque des revendications 1 à 8, dans lequel ledit substrat est un film.

10. Stratifié comprenant :
a) une feuille de cuivre,
b) un adhésif d'époxy ayant une Tg supérieure à 170°C, et
c) un substrat de polyimide suivant l'une quelconque des revendications 1 à 9,
ladite feuille ayant une adhérence au pelage supérieure à 105 N/dm lorsque détachée du stratifié telle que mesurée par la méthode d'essai IPC 2.4.8.1.

11. Stratifié suivant la revendication 10, dans lequel l'adhésif d'époxy est un adhésif d'époxy au fluorène.

12. Plaquette de circuit imprimé comprenant le stratifié suivant l'une ou l'autre des revendications 10 et 11.

13. Couche de polyimide comportant du polyimide amorphe ordonné avec une surface comprenant du polyimide amorphe désordonné.

14. Couche suivant la revendication 13, dans laquelle le polyimide a une Tg dans l'intervalle de 200°C à 600°C.

15. Couche suivant l'une ou l'autre des revendications 13 et 14, dans laquelle le polyimide précité est choisi dans le groupe comprenant le poly(4,4'-oxydiphénylènepyromellitimide), le poly(4,4'-iminodiphénylènepyromellitimide), le poly(4,4'-diphénylènepyromellitimide), le poly(4,4'-di(3,3'-diméthyl)diphénylènepyromellitimide), le poly(4,4'-oxydiphénylène-4,4',3,3'-biphényldiimide) et leurs copolymères.

16. Couche suivant l'une quelconque des revendications 13 à 15, adhérant à l'époxy d'un stratifié d'époxy/feuille de cuivre, dans laquelle l'adhérence au pelage d'un stratifié d'époxy/feuille de cuivre à ladite couche amorphe excède 105 N/dm.

17. Procédé pour améliorer un substrat de polyimide comprenant :
a) la formation d'un substrat de polyimide comportant une couche superficielle amorphe ordonnée d'une certaine épaisseur, ordonnée désignant des régions d'agrégats ordonnés dans une matrice non agrégée où la séparation moyenne entre agrégats se produit à une échelle de grandeur allant de 60 à 130 Angströms, et
b) l'irradiation d'au moins une partie de ladite épaisseur avec un rayonnement provenant d'une source d'énergie pulsée qui produit des impulsions de durée et d'intensité suffisantes pour chauffer au moins cette partie de ladite épaisseur à une température au-dessus de la température de transition vitreuse mais en dessous de la température de décomposition, en transformant ainsi au moins cette partie de ladite épaisseur en une couche superficielle amorphe désordonnée, désordonnée signifiant qu'il n'y a pas de régions ordonnées à une échelle de grandeur supérieure à 20 Angströms,
c) le refroidissement rapide de ladite couche amorphe à une température en dessous de la température de transition vitreuse avant que les molécules comprenant ladite surface amorphe désordonnée puissent se réorienter à l'état amorphe ordonné.
